# FASCICULE DE BREVET EUROPEEN

(11) **EP 3 878 005 B1**
(45) Date de publication et mention de la délivrance du brevet: **22.07.2026**
(21) Numéro de dépôt: 19813106.2
(22) Date de dépôt: 24.10.2019
(51) Int. Cl.: H10P 95/00, H10P 14/20

(54) **PROCEDE DE FABRICATION COLLECTIVE D'UNE PLURALITE DE STRUCTURES SEMI-CONDUCTRICES**
VERFAHREN ZUR KOLLEKTIVEN HERSTELLUNG EINER PLURALITÄT VON HALBLEITERSTRUKTUREN
METHOD FOR THE COLLECTIVE MANUFACTURE OF A PLURALITY OF SEMICONDUCTOR STRUCTURES

(30) Priorité: 08.11.2018 FR 1860294
(43) Date de publication de la demande: 15.09.2021
(73) Titulaire: SOITEC, 38190 Bernin (FR)
(72) Inventeur: SOTTA, David, 38100 Grenoble (FR)
(74) Mandataire: IP Trust
(86) Numéro de dépôt international: PCT/FR2019/052538
(87) Numéro de publication internationale: WO 2020/094944

(56) Documents cités:
- FR-A1- 3 056 825
- US-A1- 2012 119 218
- US-A1- 2012 241 798
- CHIU C H ET AL: "Fabrication of InGaN/GaN nanorod light-emitting diodes with self-assembled Ni metal islands", NANOTECHNOLOGY, IOP, BRISTOL, GB, vol. 18, no. 44, 7 November 2007 (2007-11-07), pages 445201, XP020129422, ISSN: 0957-4484

## Description

### DOMAINE DE L'INVENTION

La présente invention concerne un procédé de fabrication collective d'une pluralité de structures semi-conductrices.

### ARRIERE PLAN TECHNOLOGIQUE DE L'INVENTION

Un procédé de fabrication collective d'une pluralité de structures semi-conductrices est par exemple connu du document FR2992465. Dans ce document, on fournit un substrat formé d'un support, d'une couche diélectrique disposée sur la face principale du support, et d'une pluralité d'îlots de croissance en InGaN au moins partiellement relaxés. On forme ensuite un empilement de couches semi-conductrices sur les îlots de croissance pour réaliser une diode électroluminescente (LED). Cet empilement comprend une couche de contact de type n, des couches actives, une couche de contact de type p. Dans le document cité, les îlots sont de forme carrée et ont une dimension de 1 mm de côté.

La relaxation d'îlots de croissance formés d'un matériau semi-conducteur cristallin peut être obtenue au cours d'un procédé préliminaire de fabrication du substrat, tel que cela est par exemple décrit dans les documents EP2151852 ou EP2151856. On peut ainsi disposer d'îlots de croissance présentant une surface germe, apte à recevoir un empilement de couches formant la structure semi-conductrice, et dont le paramètre de maille peut être choisi. Ce paramètre de maille choisi ne peut pas toujours être fourni par une surface d'un matériau semi-conducteur massif disponible à un coût raisonnable. C'est pourquoi le procédé préliminaire de fabrication du substrat est particulièrement avantageux.

Dans le document WO2018060570 on observe qu'une couche en matériau semi-conducteur cristallin, et notamment une couche d'InGaN, formée sur un substrat « à îlot » comme celui décrit dans le document français précité, peut présenter une épaisseur non uniforme. L'épaisseur de la couche sur les bords de l'ilot peut en effet être bien différente de l'épaisseur relativement constante de la couche plus au centre de l'îlot. Cette différence d'épaisseur peut s'étendre sur une distance de l'ordre de 1 µm du bord périphérique de l'îlot de croissance.

Il est en conséquence difficile de former des couches d'épaisseur très contrôlée lorsque l'îlot présent une petite taille, par exemple lorsque l'îlot s'inscrit dans un cercle dont le diamètre est compris entre 0,1 et 5 µm. Et les structures semi-conductrices que l'on vise à former sur ces îlots de croissance de petites dimensions ne sont pas toujours fonctionnelles.

La réalisation collective, avec un bon rendement, d'une pluralité de structures semi-conductrices de petites dimensions pose donc problème, que la présente invention vise à résoudre.

### BREVE DESCRIPTION DE L'INVENTION

En vue de la réalisation de ce but, l'objet de l'invention propose un procédé de fabrication collective d'une pluralité de structures semi-conductrices, le procédé comprenant :
- la fourniture d'un substrat formé d'un support présentant une face principale, d'une couche diélectrique disposée sur la face principale du support et d'une pluralité d'îlots de croissance semi-conducteurs cristallins disposés sur la couche diélectrique ;
- la formation d'une couche active semi-conductrice cristalline sur les îlots de croissance.

Selon l'invention, le procédé comprend, après l'étape de formation de la couche active, la formation de tranchées dans la couche active et les îlots de croissance pour définir la pluralité de structures semi-conductrices.

En formant la couche active sur des îlots de croissance de relativement grandes dimensions et en définissant les structures semi-conductrices, de relativement petites dimensions, après la formation de la couche active, on limite les effets de non-uniformité en bord des îlots de croissance à un nombre limité de structures semi-conductrices, ce qui permet d'obtenir un rendement de fabrication élevé de ces structures.

Selon d'autres caractéristiques avantageuses et non limitatives de l'invention, prises seules ou selon toute combinaison techniquement réalisable :
- les îlots de croissance sont disposés directement sur, et en contact avec, la couche diélectrique ;
- la couche active est un matériau III-V ;
- les îlots de croissance sont constitués d'InGaN ;
- la formation des tranchées est conduite jusqu'à exposer la couche diélectrique ;
- les tranchées présentent une largeur comprise entre 0,1 et 5 µm ;
- les structures semi-conductrices présentent une dimension principale comprise entre 0,1 et 3 µm ;
- les îlots de croissance présentent une dimension principale comprise entre 5 microns et 2 millimètres ;
- les îlots de croissance sont séparés les uns des autres d'une distance supérieure ou égale à 5 microns ;
- le procédé comprend l'élimination d'une portion périphérique d'au moins un îlot de croissance (4) et de la couche active (6) disposée sur l'îlot.

### BREVE DESCRIPTION DES DESSINS

D'autres caractéristiques et avantages de l'invention ressortiront de la description détaillée de l'invention qui va suivre en référence aux figures annexées sur lesquels :
- Les figures 1a à 1c représentent une vue schématique en coupe d'un substrat au cours des étapes principales d'un procédé de fabrication conforme à la présente invention ;
- La figure 2a représente une vue schématique de dessus d'un substrat « à ilot » ;
- La figure 2b représente une vue schématique de dessus d'un substrat à l'issue d'un procédé conforme à l'invention.

### DESCRIPTION DETAILLEE DE L'INVENTION

La présente invention vise à fabriquer collectivement une pluralité de structures semi-conductrices de petites dimensions. On désigne dans la présente demande comme « structure semi-conductrice » tout dispositif semi-conducteur pouvant être commandé ou exploité individuellement et comprenant un empilement de couches semi-conductrices définissant une couche active, c'est à dire ayant des propriétés optoélectroniques. Il peut par exemple s'agir d'une diode électroluminescente, d'une diode laser, d'une cellule photovoltaïque ou de tout autre dispositif optoélectronique. Outre l'empilement des couches semi-conductrices formant la couche active, le dispositif fonctionnel peut comprendre d'autres éléments tels qu'un support, des plots de contact, ou des vias conducteurs, des microlentilles, permettant de le rendre effectivement fonctionnel.

Il n'est pas nécessaire que chaque structure semi-conductrice, à l'issue ou au cours du procédé de fabrication collectif, soit individualisée des autres structures pour fabriquer un dispositif totalement indépendant. Un ensemble de structures peuvent être maintenues solidaires entre elles pour être placées dans un unique boitier, tout en préservant le caractère individuellement commandable ou exploitable de chaque structure. Par exemple, le procédé peut viser à fabriquer des panneaux monolithiques de micros LEDs, chaque micros LED d'un panneau pouvant être commandée individuellement.

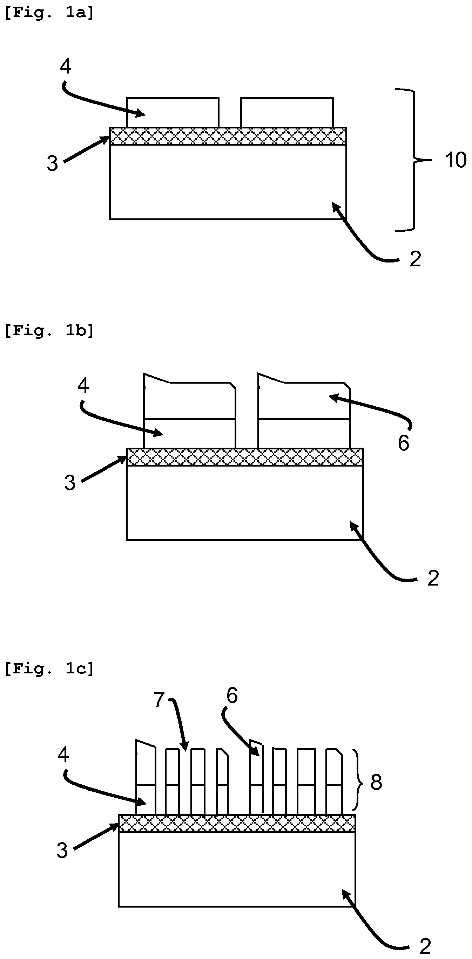

Les figures 1a à 1c représentent les étapes principales d'un procédé conforme à la présente invention. Le procédé comprend une étape initiale de fourniture d'un substrat « à îlot » 10.

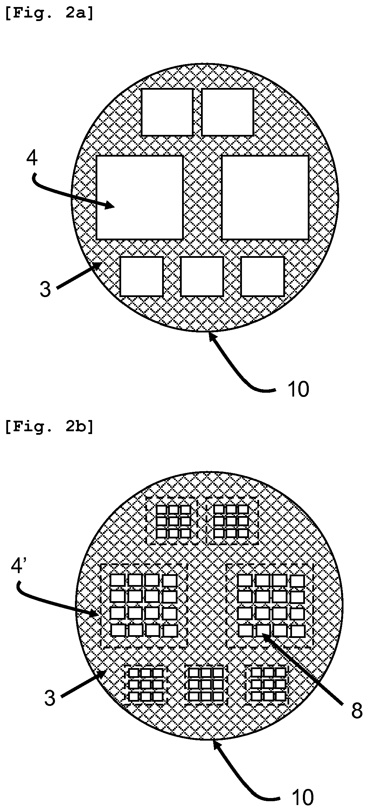

Comme cela est visible sur la vue schématique de dessus de la figure 2a, le substrat 10 peut avoir la forme d'une plaquette, circulaire, de dimension normalisée, par exemple de 2 pouces (50 mm), 4 pouces (100 mm), voire 200 mm de diamètre. Mais l'invention n'est nullement limitée à ces dimensions ou à cette forme.

Le substrat 10 comprend un support 2, par exemple en silicium ou en saphir. Le support 2 présente une face principale. Une couche diélectrique 3 est disposée sur la surface principale du support 2. La couche diélectrique 3 peut être constituée de dioxyde de silicium, de nitrure de silicium, ou d'un empilement simple ou multiple de couches constituées par exemple de ces matériaux. La couche diélectrique 3 peut présenter une épaisseur comprise entre 10 nm et plusieurs microns.

Le substrat 10 comprend également, sur la couche diélectrique 3, une pluralité d'îlots semi-conducteurs cristallins 4 (plus simplement désignés « îlots de croissance » dans la suite de la description). Par « pluralité d'îlots » on désigne un film formé d'un ensemble de zones indépendantes et non jointives, ces zones pouvant être délimitées par des tranchées exposant la couche diélectrique 3 comme cela est apparent sur la figure 1a. Les îlots peuvent tous présenter des tailles et/ou des formes identiques ou différentes entre elles.

Pour des raisons de simplicité de mise en œuvre, les îlots de croissance 4 sont disposés directement sur, et en contact avec, la couche diélectrique.

L'invention n'est nullement limitée à des îlots 4 d'une nature particulière, mais la structure 10 trouve une application particulièrement intéressante lorsque ces îlots sont constitués d'un matériau III-V, notamment d'InGaN, relaxé ou partiellement relaxé. Le matériau InGaN peut comporter une proportion d'indium compris entre 1% et 20%. Chaque îlot peut présenter une épaisseur comprise entre 100 nm et 200nm, et présenter une dimension principale dans le plan défini par le support 2 (diamètre ou longueur selon la forme de l'îlot) comprise entre quelques microns, par exemple 5 microns, et quelques mm, par exemple 2 mm. Les îlots 4 peuvent être séparés les uns des autres d'une distance supérieure ou égale à 5 microns.

On peut de la sorte former un substrat 10 présentant des îlots 4 dont les surfaces exposées présentent un paramètre de maille compris entre 0,3189 nm et 0,3220 nm, apte à recevoir au moins une couche active en matériau III-V pour constituer un dispositif semi-conducteur tel qu'une diode électroluminescente. Des procédés de fabrication d'un tel substrat « à îlots » sont par exemple décrits dans les documents EP2151852 ou EP2151856.

On pourrait également choisir de former, suivant la nature de la structure semi-conductrice qui est fabriquée, la pluralité d'îlots en AlGaN ou en tout autre matériau, tel qu'un matériau III-V, et plus particulièrement un matériau III-N.

Comme cela est représenté sur la figure 1b, le procédé de fabrication collective d'une pluralité de structures semi-conductrices comprend ensuite une étape visant à former au moins une couche semi-conductrice cristalline 6, désignée dans la suite de cet exposé par « couche active », sur les îlots de croissance 4.

À cet effet, la structure 10 peut être disposée dans une chambre d'un équipement conventionnel de croissance. Comme cela est bien connu en soi, la chambre est parcourue par des flux de gaz précurseurs, transportant les espèces constitutives de la couche active, et portée en température. Les espèces comprises dans les gaz précurseurs circulant dans la chambre, réagissent avec les surfaces exposées de la structure 10. Sur les surfaces exposées des îlots de croissance 4, une couche active cristalline 6 se forme progressivement par épitaxie.

L'équipement de croissance peut être commandé pour former une pluralité de couches semi-conductrices cristallines, pour constituer l'empilement définissant la couche active optoélectronique. Ainsi, et à titre d'exemple, lorsque le procédé de fabrication collective vise la réalisation de LEDs, on peut former sur des îlots de croissance partiellement relaxés d'InGaN dont le paramètre de maille peut être supérieur à 0.3205nm, un empilement constitué d'une couche de contact de type n présentant un désaccord en paramètre de maille avec la couche donneuse inférieur à 1% et dont l'épaisseur peut être comprise entre 100 nm et 2 microns, d'une alternance de puits quantiques et de couches barrières afin de fournir une longueur d'onde d'émission supérieure à 530 nm et d'une couche de contact de type p présentant un désaccord en paramètre de maille avec l'îlot d'InGaN inférieure à 1% et d'épaisseur comprise entre 10 nm et un micron.

À l'issue de cette étape, et quels que soient le nombre et la nature des couches semi-conductrices cristallines qui ont été déposées, on dispose à la surface de chaque îlot de croissance 4 d'une couche active 6 dont l'épaisseur n'est pas uniforme. Cette couche 6 présente, sur le contour périphérique des îlots de croissance 4, une surépaisseur ou une sous-épaisseur de matériau. Cette variation d'épaisseur périphérique peut s'étendre sur une distance d'un ou plusieurs microns du bord des îlots de croissance 4.

Au cours d'une étape suivante, représentée sur les figures 1c et 2b, on forme des tranchées 7 dans la couche active 6 et dans les îlots 4 pour définir une pluralité de structures semi-conductrices 8. La couche active 6 est entièrement traversée par les tranchées. Il n'est pas nécessaire que les îlots de croissance 4 soient entièrement ouverts par les tranchées 7, bien qu'il soit avantageux de tirer profit de la couche diélectrique 3 comme couche d'arrêt lors la formation de ces tranchées.

Les tranchées 7 peuvent être formées très simplement par des techniques de photolithographie et de gravure, sèche ou humide. Ces techniques bien connues en soi visent à masquer, à l'aide d'une résine, les zones à préserver d'un agent de gravure auquel est exposée le substrat 10. Cet agent réagit avec la surface exposée de la couche active 6 et/ou des îlots de croissance 4 pour former les tranchées 7.

À l'issue de cette étape, et comme cela est très visible sur la figure 1c, la plupart des structures semi-conductrices 8 ainsi définies présentent une couche active 6 dont l'épaisseur est très uniforme.

Les structures semi-conductrices 8 disposées sur le contour des ilots de croissance 4 peuvent présenter une non-uniformité d'épaisseur, ou présenter une épaisseur pouvant être différente de celle des couches actives formées plus au centre, à l'intérieur du contour périphérique des îlots 4. Cette caractéristique peut rendre ces structures semi-conductrices 8 non fonctionnelles, mais affecte un nombre réduit de telles structures.

Dans un mode mis en œuvre avantageux, l'étape de définition des structures semi-conductrice 8 est conduite de manière à procéder à l'élimination de la portion périphérique des îlots de croissance 4 et de la couche active 6 disposée sur ces îlots qui peut présenter une non-uniformité d'épaisseur. Lorsque les tranchées 7 sont réalisées par photolithographie et gravures, ce mode de mise en œuvre consiste alors à ne pas masquer de résine cette portion périphérique afin de l'exposer à l'agent de gravure. On évite ainsi de définir des structures semi-conductrices qui pourraient être non fonctionnelles. Le substrat obtenu à l'issu de ce mode de mise en œuvre est représenté sur la figure 2b, où il est bien visible que la portion périphérique de l'îlot 4' (délimité par le trait pointillé sur cette figure) a été éliminé.

Les tranchées 7 définissant les structures 8 sont réalisés pour être aussi réduite en largeur que possible, par exemple pour être comprises entre 0,1 microns et 5 microns.

Les structures semi-conductrices 8 définies par les tranchées 7 présentent des dimensions et des formes quelconques, qui peuvent être dictées ou choisie selon l'application visée. Il peut ainsi s'agir des formes carrées ou rectangulaires lorsque les tranchées 7 sont rectilignes et perpendiculairement croisées entre elles. Mais l'invention n'est nullement limitée à cet exemple et toute autre forme, circulaire ou octogonale par exemple, peut convenir. On saura très facilement définir la forme et l'agencement des tranchées 7 pour que les structures 8 présentent la forme choisie.

La dimension principale des structures semi-conductrices 8 (diamètre ou longueur) peut être comprises entre 0,1 micron et 3 µm.

En formant la couche active sur des îlots de croissance de relativement grandes dimensions et en définissant les structures semi-conductrices, de relativement petites dimensions, après la formation de la couche active, on limite les effets de non-uniformité en bord des îlots de croissance à un nombre limité de structures semi-conductrices, ce qui permet d'obtenir un rendement de fabrication élevé de ces structures.

Dans le cadre de la présente invention, la dimension et la forme des îlots de croissance 4 du substrat 10 sont uniquement dictées par le procédé de fabrication de ce substrat, et notamment par les étapes de relaxation de ce procédé. La dimension et/ou la forme des structures semi-conductrice 8 est quant à elle est choisie pour être parfaitement adaptée à l'application visée, en ajustant la forme et l'agencement des tranchées.

En d'autres termes, l'approche retenue par la présente invention permet de distinguer les caractéristiques des îlots de croissance 4 du substrat 10 des caractéristiques des structures semi-conductrices 8, ce qui n'était pas le cas dans les approches connues. De manière surprenante, cette approche permet d'améliorer significativement les rendements de fabrication.

On a bien entendu avantage à maximiser le rapport existant entre la dimension d'un îlot 4 et la dimension d'une structure 8, ainsi que de minimiser la surface occupée par les tranchées 7. On peut de la sorte viser à former un très grand nombre de structures semi-conductrices 8 dans chaque îlot de croissance et sur chaque support. On pourra ainsi réaliser plusieurs dizaines, voire plusieurs centaines de structures 8 sur chaque îlot de croissance 4.

Bien entendu l'invention n'est pas limitée au mode de mise en œuvre décrit et on peut y apporter des variantes de réalisation sans sortir du cadre de l'invention tel que défini par les revendications.

Un procédé conforme à l'invention peut bien entendu comprendre d'autres étapes que celles décrites en détail dans la présente description, pour rendre la structure semi-conductrice entièrement fonctionnelle. Le procédé peut ainsi comprendre la formation de contacts électriques sur des couches constituant la couche active 6 (les couches de contact p et n, pour poursuivre l'exemple précédent), le retrait du support 2 et le report des structures 8 sur un autre substrat, la singularisation et la mise en boitier de chaque structure ou d'un ensemble de structures 8.

## Revendications

1. Procédé de fabrication collective d'une pluralité de structures semi-conductrices (8), le procédé comprenant :
- la fourniture d'un substrat (10) formé d'un support (2) présentant une face principale, d'une couche diélectrique (3) disposée sur la face principale du support (2) et d'une pluralité d'îlots de croissance semi-conducteurs cristallins (4) disposés sur la couche diélectrique (3);
- la formation d'une couche active semi-conductrice cristalline (6) sur les îlots de croissance (4) ; le procédé étant caractérisé ce qu'il comprend, après l'étape de formation de la couche active (6), la formation de tranchées (7) dans la couche active (6) et les îlots de croissance (4) pour définir la pluralité de structures semi-conductrices (8).

2. Procédé de fabrication selon la revendication précédente dans lequel les îlots de croissance (4) sont disposés directement sur, et en contact avec, la couche diélectrique (3).

3. Procédé de fabrication selon l'une des revendications précédentes dans laquelle la couche active (6) est un matériau III-V.

4. Procédé de fabrication selon l'une des revendications précédentes dans lesquels les îlots de croissance (4) sont constitués d'InGaN.

5. Procédé de fabrication selon l'une des revendications précédentes dans lequel la formation des tranchées (7) est conduite jusqu'à exposer la couche diélectrique (3).

6. Procédé de fabrication selon l'une des revendications précédentes dans lequel les tranchées (7) présentent une largeur comprise entre 0,1 et 5 µm.

7. Procédé de fabrication selon l'une des revendications précédentes dans lequel les structures semi-conductrices (8) présentent une dimension principale comprise entre 0,1 et 3 µm.

8. Procédé de fabrication selon l'une des revendications précédentes dans lequel les îlots de croissance (4) présentent une dimension principale comprise entre 5 microns et 2 millimètres.

9. Procédé de fabrication selon l'une des revendications précédentes dans lequel les îlots de croissance (4) sont séparés les uns des autres d'une distance supérieure ou égale à 5 microns.

10. Procédé de fabrication selon l'une des revendications précédentes comprenant l'élimination d'une portion périphérique d'au moins un îlot de croissance (4) et de la couche active (6) disposée sur l'îlot.

## Patentansprüche

1. Verfahren zur gemeinsamen Herstellung einer Vielzahl von Halbleiterstrukturen (8), wobei das Verfahren umfasst:
- die Bereitstellung eines Substrats (10), das aus einem Träger (2) mit einer Hauptfläche, einer auf der Hauptfläche des Trägers (2) angeordneten dielektrischen Schicht (3) und einer Vielzahl von kristallinen Halbleiter-Wachstumsinseln (4), die auf der dielektrischen Schicht (3) angeordnet sind, gebildet ist;
- die Bildung einer aktiven kristallinen Halbleiterschicht (6) auf den Wachstumsinseln (4); wobei das Verfahren **dadurch gekennzeichnet ist, dass** es nach dem Schritt der Bildung der aktiven Schicht (6) die Bildung von Gräben (7) in der aktiven Schicht (6) und den Wachstumsinseln (4) umfasst, um die Vielzahl von Halbleiterstrukturen (8) zu definieren.

2. Herstellungsverfahren nach dem vorstehenden Anspruch, bei dem die Wachstumsinseln (4) direkt auf der dielektrischen Schicht (3) und in Kontakt mit dieser angeordnet sind.

3. Herstellungsverfahren nach einem der vorstehenden Ansprüche, wobei die aktive Schicht (6) ein III-V-Material ist.

4. Herstellungsverfahren nach einem der vorstehenden Ansprüche, bei dem die Wachstumsinseln (4) aus InGaN bestehen.

5. Herstellungsverfahren nach einem der vorstehenden Ansprüche, bei dem das Ausbilden der Gräben (7) so lange fortgesetzt wird, bis die dielektrische Schicht (3) freigelegt ist.

6. Herstellungsverfahren nach einem der vorstehenden Ansprüche, bei dem die Gräben (7) eine Breite zwischen 0,1 und 5 µm aufweisen.

7. Herstellungsverfahren nach einem der vorstehenden Ansprüche, bei dem die Halbleiterstrukturen (8) eine Hauptabmessung zwischen 0,1 und 3 µm aufweisen.

8. Herstellungsverfahren nach einem der vorstehenden Ansprüche, bei dem die Wachstumsinseln (4) eine Hauptabmessung zwischen 5 Mikrometern und 2 Millimetern aufweisen.

9. Herstellungsverfahren nach einem der vorstehenden Ansprüche, bei dem die Wachstumsinseln (4) einen Abstand von 5 Mikrometern oder mehr voneinander aufweisen.

10. Herstellungsverfahren nach einem der vorstehenden Ansprüche, umfassend das Entfernen eines Randbereichs mindestens einer Wachstumsinsel (4) und der auf der Insel angeordneten aktiven Schicht (6).

## Claims

1. Method for the collective production of a plurality of semiconductor structures (8), the method comprising:
- providing a substrate (10) formed by a support (2) having a main face, a dielectric layer (3) disposed on the main face of the support (2) and a plurality of crystalline semiconductor growth islands (4) disposed on the dielectric layer (3);
- forming a crystalline semiconductor active layer (6) on the growth islands (4); the method being **characterised in that** it comprises, after the step of forming the active layer (6), forming trenches (7) in the active layer (6) and the growth islands (4) in order to define the plurality of semiconductor structures (8).

2. Production method according to the preceding claim, wherein the growth islands (4) are disposed directly over, and in contact with, the dielectric layer (3).

3. Production method according to one of the preceding claims, wherein the active layer (6) is a III-V material.

4. Production method according to one of the preceding claims, wherein the growth islands (4) are made of InGaN.

5. Production method according to one of the preceding claims, wherein forming the trenches (7) is conducted until the dielectric layer (3) is exposed

6. Production method according to one of the preceding claims, wherein the trenches (7) have a width between 0.1 and 5 µm.

7. Production method according to one of the preceding claims, wherein the semiconductor structures (8) have a main dimension between 0.1 and 3 µm.

8. Production method according to one of the preceding claims, wherein the growth islands (4) have a main dimension between 5 microns and 2 millimetres.

9. Production method according to one of the preceding claims, wherein the growth islands (4) are separated from each other by a distance greater than or equal to 5 microns.

10. Production method according to one of the preceding claims comprising removing a peripheral portion of at least one growth island (4) and the active layer (6) disposed on the island.
